Europäisches Patentamt

European Patent Office

Office européen des brevets

(19)

(11) Publication number: **0 081 342**

**A1**

(12)

# EUROPEAN PATENT APPLICATION

(21) Application number: **82306428.2**

(22) Date of filing: **03.12.82**

(51) Int. Cl.³: **C 23 D 5/06**
**H 05 K 3/44**

(30) Priority: **04.12.81 GB 8136652**

(43) Date of publication of application:
**15.06.83 Bulletin 83/24**

(84) Designated Contracting States:
**AT BE CH DE FR GB IT LI LU NL SE**

(71) Applicant: **COOKSON GROUP plc**
**14 Gresham Street**
**London EC2V 7AT(GB)**

(72) Inventor: **Barnes, Allan Francis**
**14 Gresham Street**
**London, EC2V 7AT(GB)**

(72) Inventor: **Wallace, Clarence Livingston**
**1621 S. Rancho Santa Fe Road**
**San Marcos, CA 92069(US)**

(74) Representative: **Marsh, Roy David et al,**
**Brewer & Son 5-9, Quality Court Chancery Lane**
**London WC2A 1HT(GB)**

(54) Method and apparatus for the production of vitreous enamelled substrates.

(57) A method of producing a vitreous enamelled, printed article (42) is characterised by printing (19) a pattern onto a tape (17), band cast from a homogeneous and air-free liquid mixture (13) containing a vitreous constituent and a binder, laminating (24) the printed tape to a base and then firing (41) to bond the tape to the base.

The invention has particular application to the production of electrical printed circuits comprising a plurality of printed vitreous layers carried on a metal base. The tape provides a flat surface on which to print a circuit pattern, unlike the uppermost surface of a laminated printed circuit precursor or substrate. Printing on a flatter surface reduces the likelihood of flaws and discontinuities appearing in the circuit pattern in the printing thereof.

EP 0 081 342 A1

Croydon Printing Company Ltd.

## METHOD OF, AND APPARATUS FOR THE PRODUCTION
## OF VITREOUS ENAMELLED SUBSTRATES.

### FIELD OF THE INVENTION.

This invention relates to a method of an apparatus for
the production of vitreous enamelled substrates.

### BACKGROUND OF THE INVENTION.

Substrates used for the production of thick film and
integrated circuits may be produced by the application of
a layer of vitreous or porcelain enamel to a base, which
is generally metallic and usually steel.  The vitreous
enamel is usually applied to the base by dipping,
spraying or electrophoretic deposition but other methods
are sometimes employed and is then fired to cause fusion
or sintering of the enamel into a coating adherent to the
base.  The enamel when applied to the base may have all
or some of its constituents premixed, presintered or
premelted or a mixture of the enamel constituent may be
applied.

These existing method suffer from disadvantages.  It is
difficult to achieve flatness when enamel powder is
applied to the base and this lack of flatness is
reproduced to a lesser or greater extent when the coating
has been fired.  A lack of flatness causes problems when
circuitry is applied to the surface, typically but not
exclusively by the process known as silk screen printing
wherein the screen material is usually synthetic fibre or
metal.  Also, the enamel-applying techniques at present
in use frequently allow air bubbles to exist in the final
fired coating leading to a reduction in the electrical resistance value. Also, the thicker the coating which is applied, the greater is the problem of unevenness of coating and the occurrence of air bubbles, so that the maximum thickness of coating which can be applied in practice may be less than desirable for certain applications.

It has been proposed to build up a multi-layer coating by alternate steps of laying down a vitreous coating layer and printing a pattern on it. Typically, each coating step lays down a thickness of material of 75μm and each printing step lays down a thickness of printed material of 10 or 15 μm. Thus, the exposed surface of a coating layer which overlies a printed pattern is unlikely to be so perfectly flat as the metal base on which the coating layers are built up. With each successive cycle of coating and printing in the manufacture of a multi-layer coating the departure from flatness is likely to be greater, making it increasingly difficult to print reliably onto the exposed surface of the multi-layer article under manufacture, and increasingly likely that flaws and discontinuities will be present in the pattern laid down by that printing step.

Where successive coating and printing steps are interspersed by one or more firing steps it is likely that quality control procedures will be employed to eliminate unacceptable substrates at as early a stage as possible. Thus, the value of the substrate can have increased to a substantial level by the time the substrate is subjected to the final printing step.

However, it is precisely at this last printing step when the departure from flatness is greatest and therefore also the likelihood of a flaw or discontinuity appearing in the last pattern printed. Rejection of a substrate at this stage is likely to be substantially more expensive than rejection at an early stage.

There is a tendency for iron ions from the substrate to migrate into the enamel surface causing electrical problems and such migration is usually precluded or minimised by applying a barrier layer of some sort usually nickel to the surface of the steel.

Where a pattern is to be printed onto a vitreous coating which overlies the barrier layer, the barrier layer must be as flat as possible for the reasons explained above. Accordingly, care is needed to see that the exposed surface of the barrier layer is as flat as possible.

Where a thick film circuit is printed onto the exposed surface of a substrate, which is then fired, only precious metals are capable of withstanding the firing environment. Resistor components of the circuit are formed from ruthenium because carbon is unstable during firing. The use of these materials adds to the cost of circuit manufacture.

SUMMARY OF THE INVENTION.

It is an object of the present invention to provide economies in the manufacture of thick film circuits on enamelled metal substrates by removing, or at least

- 4 -

mitigating, some or all of the above-mentioned disadvantages of the already-proposed manufacture.

According to the present invention there is provided a method of producing a vitreous enamelled, printed article characterised by the steps of printing a pattern onto a tape, band cast from a homogeneous and air-free liquid mixture containing a vitreous constituent and a binder, laminating the printed tape to a base, and then firing to bond the tape to the base.

The invention also provides apparatus for carrying said method into effect, and vitreous enamelled printed articles made by the method and with the apparatus.

With the invention, there is greater likelihood of printing without flaws and discontinuities because printing is always onto a flat tape rather than onto the exposed surface of the uppermost layer of a substrate, which may be far from perfectly flat. Economies will result from the reduced need for the substrate to be perfectly flat.

The invention holds out the possibility of printing a circuit of substances other than precious metals. Where the printed pattern is shielded from the firing furnace environment by an overlying layer of vitreous material such substances as copper, nickel and carbon would survive the firing temperatures and could be used, with consequent substantial cost saving over the use of precious metals. The shielding layer could be provided simply by arranging for the printed face of the tape to face inwardly onto the underlying layer of the substrate, rather than outwardly.

The vitreous constituent of the enamel should be free from sodium and potassium and may, for example, be an oxide of magnesium, calcium, silicon or boron or a mixture of such oxides.

The binder may, for example, be polyvinylchloride, polyvinylacetate or methylmethacrylate. It will usually be provided as a liquid binder system by mixing it with a solvent and a plasticiser. For the solvent, a mixture of methyl ethyl ketone and toluene gives a satisfactory rate of solvent evaporation in drying of the cast tape. A suitable plasticiser is dibutyl phthalate.

In carrying out the method, a mixture of ground enamel materials and a binder system, which forms a slurry, is slowly stirred under vacuum so that entrapped air bubbles are eliminated. The mixture is then transferred gently to avoid entrapment of air to a band casting machine in which it is cast to uniform thickness on a backing tape provided by a travelling band, e.g. of polyester. A tape may be cast on the band to any desired thickness and this process produces cast tape with a very flat and level surface. After drying to remove the solvent, the tape, now consisting of enamel constituents and binder, is easy to handle and has a rubber-like consistency. It is parted from the backing tape and either stored on a reel or fed to a printing apparatus where, by a screen printing technique, a thick film circuit pattern is printed repetitively along the length of the tape, with

- 6 -

the provision of indexing marks, to facilitate further manipulation of the printed tape.

The printed tape can then be laminated to a steel or other base with or without the use of a surface coating to act as an adhesive to bind the tape to the base. The tape may be laminated to one or both surfaces of the base. After lamination the product is fired to fuse or sinter the enamel layer and to cause it to bond to the base.

Instead of applying a single layer of tape of enamel/binder it is possible to apply two or more layers. The individual layers may be of the same or different compositions. Thus the individual layers may have different electrical or mechanical properties or the layer next to a steel base may have good adhesion properties or may prevent or reduce the tendency for iron to migrate into the layer from the steel. In this case if the composition of the layer adjacent to the steel has less satisfactory electrical properties a composition may be chosen for the outer layer which will adhere to the first layer and has superior electrical properties or a superior surface onto which the circuitry could be printed.

BRIEF DESCRIPTION OF THE DRAWING.

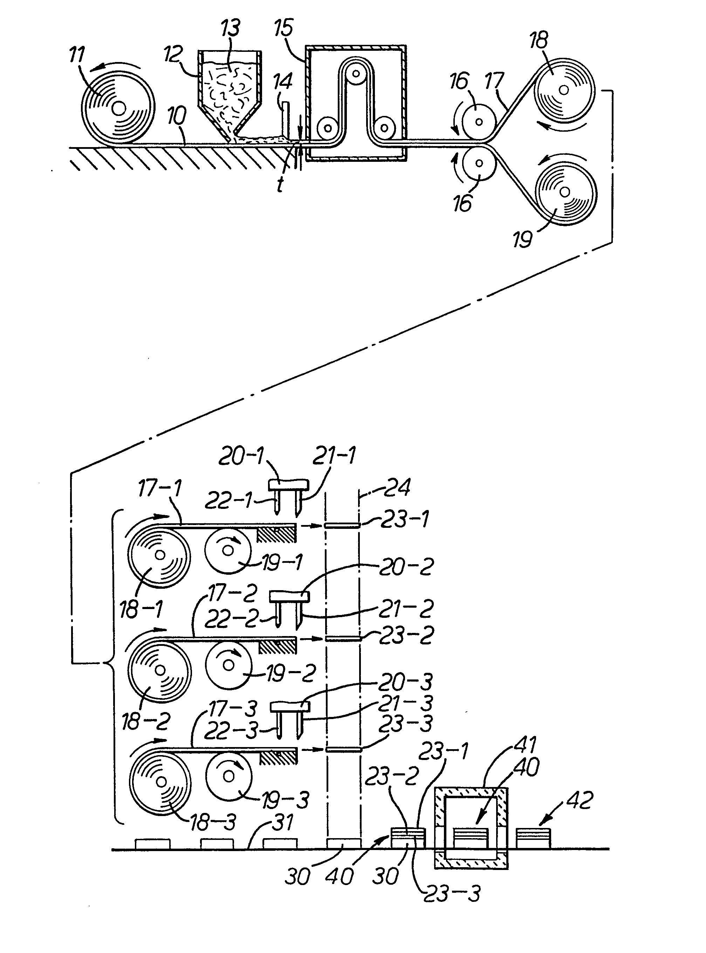

Figures 1 and 2 of the drawing together provide a single block diagram showing process steps in the preparation of a vitreous enamelled, printed article, in accordance with the present invention.

DETAILED DESCRIPTION.

Referring to the drawing, a polyvinylchloride or polyvinylacetate backing tape 10 drawn from a supply reel 11 passes under a dispenser 12 of a slurry of enamelling material 13 which is thereby deposited onto the tape 10. A doctor blade 14 acts to define a thickness $t$ of enamelling material 13 on the tape and to provide a flat exposed surface of the enamelling material.

The coated tape 10 is drawn through a drying chamber 15 which acts to remove solvent from the enamelling material, which thereby dries to a rubbery consistency. Upon emergence from the drying chamber 15 the coated tape 10 is fed between a pair of rollers 16 and the rubbery layer 17 of vitreous material and dried binder 13 is parted from the backing tape 10 to be wound onto a storage drum 18. The backing tape 10 is stored on its own supply drum 19 identical to the drum 11.

For printing, three (or any other desired number) drums 18-1, 18-2 and 18-3 each charged with vitreous material, which may be different in composition as required, supply three screen printing presses 19-1, 19-2 and 19-3 respectively, whereby desired thick film circuit patterns in inks composed of such materials as precious metals or nickel, copper and carbon are laid down on the undersurface of the tapes 17-1, 17-2 and 17-3 issuing from the storage drums. The printed patterns include registry marks.

These marks (not shown) are detected and recognised by three cutting devices 20-1, 20-2 and 20-3, one for each of the three tapes. Each of these devices has a shearing blade 21 which severs the tape across its full width into discrete lengths 23 each carrying one circuit pattern, and one or more via-forming blades 22 which cut whatever through apertures are required in the fired enamel.

The severed tape pieces 23 are fed to a stacking device 24 in which they are placed accurately on top of one another on a metal base plate 30 delivered to the stacking device along a conveyor 31. It may be convenient to dampen the tape pieces 23 with solvent to ensure that they adhere to one another and to the base plate 30. Alternatively, an adhesive layer, or surface coating on the base plate, may be used for this purpose.

The relevant techniques of tape casting and printing are known to those skilled in the art, and suitable apparatus is available from a number of suppliers.

Suitable stacking devices are obtainable from Cladan Technology Inc. of 1621 South Rancho Santa Fe Road, San Marcos, California 92069, U.S.A.

From the stacking device 24 emerge thick film circuit precursors 40 which comprise the metal base 30 and three overlying layers of printed tape 23. These precursors 40 are fed to a firing furnace 41 in which firing is carried out in a gaseous environment and within a range of temperatures with which those skilled in the art will be familiar. Firing drives out from the printed circuit articles the substances used as binders for the vitreous materials and fuses these latter materials thereby to create enamels. Thus, there emerge from the firing furnace 41 functional thick film, printed circuits 42 carried on a metal base and protected by an envelope of enamel. It will be understood that the firing kiln gases do not contact the printed pattern on the underside of any of the tape pieces 23-1, 23-2 and 23-3 so that the relatively unstable materials used in these patterns nevertheless survive the firing step.

There may, however, be a need to use some precious metals for circuit printing, for example, where the pattern is vulnerable to attack by the kiln gases such as at vias and near the other edges of the circuit precursor 40.

The invention is likely to be useful in applications where it is impracticable to print a circuit pattern onto a vitreous material already mounted on a metal base. For example, small tape pieces could be mounted in situ on a large metal member and then fired in situ. One such application is in the assembly of panels such as automobile dashboards and fascias, where the present arrays of wiring and circuit components which have to be fastened to the back of the panel could be replaced by placing small pieces of printed vitreous tape on the back face of the panel and firing them in situ so that all that remains to do in order to complete assembly of the panel is to make electrical connections between the various electrical components of the vehicle and the thick film circuits fired to the panel, and between the circuits and the panel displays on the front face of the panel.

The invention will now be illustrated by the following specific Examples.

Example 1.

A ground enamel composition sold under the designation EL-2010 by Ferro Corporation of Cleveland, Ohio, U.S.A. was mixed with 20 to 30% of its weight of a binder system having the following formulation:

A    20-35% methyl ethyl ketone

B    20-35% toluene

C    5-15% methylmethacrylate

D    0.5-5% dibutyl phthalate

E    0-2% lecithin.

The mixture was de-aerated and cast on a P.V.C. backing tape onto a tape 250 μm thick. The tape was dried and then screen printed with a thick film circuit pattern.

The printed tape was laminated, with a copper clad Invar (trade mark) base plate with the printed face of the tape contacting the metal base. The laminated circuit precursor was fired to fuse the enamel. The fired enamel coating was approximately 150 μm thick and exhibited similar electrical properties to those quoted by the manufacturer of the vitreous composition as being obtainable through the use of other coating methods. The circuitry was found to be conductive when tested through holes in the overlying enamel layer.

Where lecithin was present in the binder system, it was added as a dispersant.

## Example 2.

The steps of Example 1 were followed, except that a vitreous material of designation EL-202- was applied to a base plate of enamelling grade steel. The electrical properties were as stated in Example 1, and similar to those quoted by the manufacturer.

## Example 3.

The steps of Example 2 were followed, except that the vitreous material used was as specified in Example 30 of the specification of U.S. Patent No. 4256796. The electrical properties of the enamel were found to be similar to those quoted in the patent specification as being obtainable by the preferred coating method of electrophoretic deposition, and the circuitry was again found to be conductive.

## Example 4.

The steps of Example 1 were followed, except that the tape was cast with a thickness of 75 μm. Three layers of such tape were printed and laminated onto the base plate before the firing step. The electrical properties of the enamel were as stated in Example 1.

0081342

- 12 -

<u>CLAIMS</u>:

1. A method of producing a vitreous enamelled, printed article characterised by the steps of printing a pattern onto a tape, band cast from a homogeneous and air-free liquid mixture containing a vitreous constituent and a binder, laminating the printed tape to a base, and then firing to bond the tape to the base.

2. A method according to claim 1 characterised in that the pattern is that of an electrical circuit.

3. A method according to claim 1 or 2 characterised in that the step of printing is effected by a thick film screen printing technique.

4. A method according to any one of the preceding claims wherein the pattern is formed from an ink the essential constituent of which is selected from copper, nickel and carbon.

5. A method according to any one of the preceding claims characterised in that the binder is provided as a binder system which comprises an enamel substance, a plasticiser and a solvent, being a mixture of methylethyl ketone and toluene present in similar or equal proportions by weight.

6. A method according to any one of the preceding claims characterised in that said tape is a base tape and in that at least one further tape is laminated to the base tape.

7.　　　A method according to claim 6 characterised in that at least the base tape and one further tape are laminated to the base before said step of firing.

8.　　　Apparatus for producing a vitreous enamelled, printed electrical logic circuit characterised by means (19) for printing a pattern onto a band cast tape (17) of a vitreous constituent and a binder, means (24) for laminating the printed tape (23) to a metal base plate (30) and means (41) for firing to bond the tape to the base plate.

9.　　　An electrical logic circuit in an enamel layer on a metal base plate formed by use of a method according to claim 1 or apparatus as claimed in claim 8.

1/1

European Patent
Office

**EUROPEAN SEARCH REPORT**

Application number

EP 82306428.2

| Category | Citation of document with indication, where appropriate, of relevant passages | Relevant to claim | CLASSIFICATION OF THE APPLICATION (Int. Cl. ³) |
|---|---|---|---|
| | **DOCUMENTS CONSIDERED TO BE RELEVANT** | | |
| A | GB - A - 2 074 152 (INTERNATIONAL CERAMICS LTD.) <br><br> * Page 1, lines 51-100; page 2, lines 51-64 * <br> -- | 1-3,5-9 | C 23 D 5/06 <br> H 05 K 3/44 |
| A | GB - A - 1 079 960 (BURGER EISEN-WERKE) <br><br> * Page 1, lines 43-64; page 1, line 79 - page 2, line 45; fig. * <br> ---- | 1,3,6,7 | |
| | | | **TECHNICAL FIELDS SEARCHED (Int. Cl. ³)** <br><br> C 23 D <br> H 05 K |

The present search report has been drawn up for all claims

| Place of search | Date of completion of the search | Examiner |
|---|---|---|
| VIENNA | 03-03-1983 | HAUSWIRTH |